(19) Europäisches Patentamt
European Patent Office
Office européen des brevets

(11) **EP 2 763 008 A2**

(12) **EUROPÄISCHE PATENTANMELDUNG**

(43) Veröffentlichungstag:
06.08.2014 Patentblatt 2014/32

(51) Int Cl.:
*G06F 3/041* (2006.01)    *G06F 3/044* (2006.01)

(21) Anmeldenummer: **14153453.7**

(22) Anmeldetag: **31.01.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **01.02.2013 DE 102013201704**

(71) Anmelder: **Di-Soric GmbH & Co. KG, Urbach 73660 Urbach (DE)**

(72) Erfinder: **Laubisch, Ralf 57489 Drolshagen (DE)**

(74) Vertreter: **Emig, Ralf et al Patentanwälte Maikowski & Ninnemann Postfach 15 09 20 10671 Berlin (DE)**

(54) **Kapazitive Sensoranordnung und kapazitives Messverfahren mit Kompensation parasitärer Kapazitäten**

(57) Die vorliegende Erfindung betrifft eine Sensoranordnung sowie ein Verfahren zur Messung einer Kapazitätsänderung an wenigstens einer Sensorelektrode gegenüber einer Grundkapazität, wobei die Grundkapazität (Co) den bei einer Messung konstanten Grundanteil einer Messkapazität ($C_x$) bildet und wobei
- die Sensorelektrode mit einer Auswerteschaltung gekoppelt ist, die wenigstens einen Verstärker (I) und einen dem Verstärker (I) nachgeschalteten Schmitt-Trigger (ST) umfasst, und
- über die Auswerteschaltung die Sensorelektrode (SE) wiederholt entladbar und aufladbar ist, so dass anhand der Frequenz, mit der das Entladen und Aufladen erfolgt, an einem dem Schmitt-Trigger (ST) nachgeschalteten Ausgang (A) auf die Größe der Messkapazität ($C_x$) an der Sensorelektrode (SE) geschlossen werden kann.

Erfindungsgemäß liegt an einem Eingang (5) des Verstärkers (I) die Spannung über der Sensorelektrode (SE) an und an einem Ausgang (7) des Verstärkers (I) wird eine Kompensationsspannung erzeugt, wobei eine Kompensationskapazität (Cp) vordefinierter elektrischer Kapazität mit dem Ausgang (7) des Verstärkers (I) verbunden und zu dem Verstärker (I) parallel geschaltet ist, so dass die mitgemessene Grundkapazität (Co) der Sensorelektrode (SE) verringert ist, um bei der Messung parasitäre Kapazitäten zu kompensieren.

FIG 2

EP 2 763 008 A2

**Beschreibung**

Die vorliegende Erfindung betrifft eine Sensoranordnung zur Messung einer Kapazitätsänderung an wenigstens einer Sensorelektrode gemäß dem Oberbegriff des Anspruchs 1 sowie ein Verfahren zur Messung einer Kapazitätsänderung an wenigstens einer Sensorelektrode.

Bei einer derartigen kapazitiv arbeitenden Sensoranordnung wird üblicherweise die sich ändernde Kapazität zwischen der Sensorelektrode und der Elektronikmasse bzw. -erde gemessen, um festzustellen, ob sich in der Umgebung der Sensorelektrode ein Objekt befindet und/oder - bei Verwendung der Sensoranordnung zur Abstandsmessung - ein Objekt der Sensorelektrode genähert hat.

Aus der DE 195 12 150 A1 ist beispielsweise eine Sensoranordnung für ein Eingabegerät, wie z. B. einen Bildschirm, bekannt, bei dem eine Sensor- bzw. Nutzelektrode, eine die Sensorelektrode schirmende Schirmelektrode sowie eine Ablenkelektrode vorgesehen sind und über eine Auswerteschaltung die Sensorelektrode wiederholt entladbar und aufladbar ist, um anhand der Frequenz, mit der das Entladen und Aufladen erfolgt, an einem Ausgang der Auswerteschaltung auf die Größe der Kapazität an der Sensorelektrode zu schließen und hierüber eine Eingabe durch einen Nutzer an dem Eingabegerät kapazitiv zu erkennen. Mittels der Ablenkelektrode - auch als Feldbündelelektrode bezeichnet - wird ein von der Sensorelektrode erzeugtes elektrisches Feld beeinflusst und dieses in einem relevanten Messbereich gebündelt.

Bei einer Sensoranordnung zur Messung einer Kapazitätsänderung an wenigstens einer Sensorelektrode gegenüber einer Grundkapazität besteht nun grundsätzlich das Problem, dass insbesondere in der mit der Sensorelektrode gekoppelten Auswerteschaltung zahlreiche parasitäre Kapazitäten vorhanden sind, wodurch der Messeffekt reduziert wird. Dies ist insbesondere bei Anwendungen störend, bei denen die festzustellende Kapazitätsänderung vergleichsweise gering ist, z. B. im Bereich weniger pF oder sogar unter 1 pF liegt. Gerade bei einer Sensoranordnung für die Abstandsmessung zweier Komponenten in einer Werkzeugmaschine sind derartige Kapazitätsänderungen häufig entscheidend, um beispielsweise die genaue Position eines Werkzeugschlittens festzustellen.

Es ist daher Aufgabe der vorliegenden Erfindung, eine Sensoranordnung bereitzustellen, bei der der Messeffekt vergrößert ist und sich insbesondere kleinere Kapazitätsänderungen mit größerer Genauigkeit messen lassen.

Diese Aufgabe wird mit einer Sensoranordnung gemäß dem Anspruch 1 sowie mit dem Messverfahren des Anspruchs 15 gelöst.

Bei dieser Sensoranordnung ist die Sensorelektrode mit einer Auswerteschaltung gekoppelt, die wenigstens einen Verstärker, z. B. einen nicht-invertierenden Operationsverstärker, und einen dem Verstärker nachgeschalteten Schmitt-Trigger umfasst. Über die Auswerteschaltung ist die Sensorelektrode wiederholt entladbar und aufladbar, so dass anhand der Frequenz, mit der das Entladen und Aufladen erfolgt, an einem dem Schmitt-Trigger nachgeschalteten Ausgang auf die Größe der Kapazität an der Sensorelektrode geschlossen werden kann. So verändert sich die Kapazität an der Sensorelektrode beispielsweise durch ein Objekt, das in ein durch die Sensorelektrode erzeugtes elektrisches Feld eindringt. Damit ändert sich die Frequenz, mit der die Ladung und Entladung der Sensorelektrode erfolgt, in charakteristischer Weise, so dass anhand der Frequenz die Größe der Kapazität an der Sensorelektrode bzw. die Änderung gegenüber der Grundkapazität bestimmt werden kann.

Erfindungsgemäß ist nun weiterhin vorgesehen, dass an einem Eingang des Verstärkers die Spannung über der Sensorelektrode anliegt und an einem Ausgang des Verstärkers eine Kompensationsspannung erzeugt wird sowie eine Kompensationskapazität vordefinierter elektrischer Kapazität mit dem Ausgang des Verstärkers verbunden und zu dem Verstärker derart parallel geschaltet ist, dass sich die Grundkapazität verringert, um parasitäre Kapazitäten bei der Messung zu kompensieren. Mit anderen Worten ist eine Kompensationskapazität vordefinierter elektrischer Kapazität mit dem Ausgang des Verstärkers verbunden und zu dem Verstärker parallel geschaltet, so dass die mitgemessene Grundkapazität der Sensorelektrode - insbesondere gegenüber einer Sensoranordnung ohne Kompensationskapazität - verringert ist, um bei der Messung parasitäre Kapazitäten zu kompensieren. Durch die Kompensation der parasitären Kapazitäten mittels der Kompensationsspannung und der zusätzlichen Kompensationskapazität wird eine erhebliche Steigerung des Messeffekts und damit der Sensorempfindlichkeit erreicht.

Durch die erfindungsgemäße Lösung kann ein Abgleich der Sensoranordnung bei oder nach der Montage weitestgehend oder - je nach Schaltungslayout - auch vollständig vermieden werden. Ferner kann eine erfindungsgemäße Sensoranordnung vergleichsweise einfach auch in kleinsten Bauformen und mit wenigen (diskreten) Bauteilen ausgeführt werden, ohne dass diese unmittelbar zu einer erheblichen Verkleinerung der Schaltabstände führt. So hat sich gezeigt, dass grundsätzlich mit einer erfindungsgemäßen Sensoranordnung teilweise deutlich größere Schaltabstände realisierbar sind als bei vergleichbaren Sensoranordnungen ohne Kompensationskapazität.

Die Kompensationskapazität kann grundsätzlich über ein geschickt gewähltes Schaltungslayout in die Schaltungsanordnung eingebracht sein, so dass ohnehin vorzusehende und bei der Messung kapazitiv wirkende Schaltungsteile (z.B. Leitungen) als eine Kompensationskapazität fungieren, mit der eine gemessene Grundkapazität der Sensorelektrode verringert wird. Darüber hinaus kann eine Kompensationskapazität über wenigstens ein separates bzw. diskretes vorzugsweise kapazitives Bauelement, z.B. in Form eines Kondensators, bereitgestellt sein, dass zur Kompensation parasitärer Kapazitäten gezielt auf die erfindungsgemäße Art und Weise in der Schaltungsanordnung angeordnet wurde. Eine Kompensationskapazität kann somit insbesondere durch ein diskretes elektrisches Bauelement oder mehrere diskrete elektrischen Bauelemente in der Sensoranordnung bzw. einer zugehörigen Schaltung bereitgestellt sein.

In einer bevorzugten Ausführungsvariante ist zusätzlich zu der wenigstens einen Sensorelektrode eine Feldbündelelektrode vorgesehen, die derart ausgebildet und geschaltet ist, dass ein von der Feldbündelelektrode erzeugtes elektrisches Feld eine räumliche Verteilung eines von der Sensorelektrode erzeugten elektrischen Feldes derart beeinflusst, dass das Feld der Sensorelektrode in einem räumlichen Messbereich gebündelt ist. Eine derartige Feldbündelelektrode kann beispielsweise mindestens eine Sensorelektrode teilweise oder vollständig umlaufend umgeben, so dass eine Bündelung des von der Sensorelektrode erzeugten elektrischen Felds in dem von der Feldbündelelektrode umgebenden Bereich erreicht wird.

In einer als besonders vorteilhaft erachteten Ausführungsvariante einer erfindungsgemäßen Sensoranordnung mit einer Feldbündelelektrode ist die Feldbündelelektrode mit dem Ausgang des Verstärkers verbunden und die Feldbündelelektrode liegt damit auf dem Potential der Kompensationsspannung. Hierbei ist dann die zur Kompensation parasitärer Kapazitäten vorgesehene zusätzliche Kompensationskapazität zwischen die Feldbündelelektrode und die Sensorelektrode geschaltet. Indem die zur Kompensation parasitärer Kapazitäten vorgesehene und ausgebildete Kompensationskapazität zwischen den auf unterschiedlichen Potentialen liegenden Elektroden angeordnet ist, wird eine besonders effektiv arbeitende Sensoranordnung erzielt, die eine zusätzliche Feldbündelelektrode aufweist und bei der der Messeffekt gegenüber bekannten Sensoranordnungen deutlich verbessert ist.

Zur Unterdrückung hochfrequenter Störungen bei der Messung mit Hilfe der Sensoranordnung wird es ferner bevorzugt, dass zwischen dem Verstärker und dem Schmitt-Trigger ein Tiefpass geschaltet ist. Zur Unterdrückung hochfrequenter Störungen kann es zudem vorteilhaft sein, zwischen der Sensorelektrode und dem Verstärker eine Induktivität vorzusehen.

In einer bevorzugten Ausführungsvariante ist die Auswerteschaltung ferner dazu ausgebildet und vorgesehen, mit einer einzelnen asymmetrischen Versorgungsspannung betrieben zu werden. Hierzu werden beispielsweise die Fußpunkte des Schmitt-Triggers und eines nicht-invertierenden Verstärkers über einen Spannungsteiler aus zwei gleichgroßen, relativ niederohmigen Widerständen zwischen der Versorgungsspannung und Masse angeschlossen.

In einer möglichen Weiterbildung einer erfindungsgemäßen Sensoranordnung weist diese eine zweite Sensorelektrode und/oder vorteilhaft einem dem Verstärker vorgeschalteten aktiven Integrierer auf. Beide Sensorelektroden bilden eine Gegenkopplungskapazität des Integrieres. Eine Feldbündelelektrode kann auch hier optional zwischen dem - vorzugsweise nicht-invertierenden - Verstärker und der zur Kompensation parasitärer Kapazitäten vorgesehenen Kompensationskapazität angeordnet werden.

In einer Ausführungsform der vorliegenden Erfindung ist die komplette Auswerteschaltung, insbesondere mit (nicht-invertierendem) Verstärker und Schmitt-Trigger, auf einer Leiterplatte untergebracht.

Hier kann eine weitere Reduzierung parasitärer Kapazitäten erreicht werden, indem eine in dieser Hinsicht optimierte Schaltungs- und Layout-Gestaltung verwendet ist. In diesem Zusammenhang hat sich beispielsweise eine Sensoranordnung als besonders vorteilhaft herausgestellt, bei der

- der der Sensorelektrode nachgeschaltete Operationsverstärker mehrere an der Leiterplatte nebeneinander liegende Anschlusspins aufweist,
- die Sensorelektrode mit dem nicht-invertierenden Eingang des Operationsverstärkers über einen Anschlusspin des Operationsverstärkers verbunden ist und
- dieser Anschlusspin zum einen den äußersten Anschlusspin der nebeneinander liegenden Anschlusspins bildet und dieser mit der Sensorelektrode verbundene Anschlusspin zum anderen unmittelbar neben dem Anschlusspin für den invertierenden Eingang des Operationsverstärkers liegt.

Indem damit kein weiterer Anschlusspin zwischen dem mit der Sensorelektrode verbundenen äußersten Anschlusspin für den nicht-invertierenden (positiven) Eingang des Operationsverstärkers und dem Anschlusspin für den invertierenden (negativen) Eingang desselben Operationsverstärkers liegt, können parasitäre Kapazitäten zusätzlich reduziert werden. So regelt der Operationsverstärker von sich aus eine Spannungsdifferenz zwischen den beiden Eingängen (+ und -) zu Null, so dass durch den Anschlusspin für den invertierenden Eingang keine größeren parasitären Kapazitäten bei der Messung hervorgerufen werden.

In bevorzugten Ausführungsvarianten ist die Sensoranordnung dazu ausgebildet und vorgesehen, durch eine sich ändernde Kapazität an der Sensorelektrode zu bestimmen, ob sich ein Objekt der Sensorelektrode genähert hat und/oder sich ein Objekt in einem Umgebungsbereich um die Sensorelektrode befindet. Derart kann eine erfindungsgemäße Sensoranordnung in einem Näherungsschalter oder -sensor Anwendung finden.

Eine bevorzugte Anwendung sieht vor, dass durch eine sich ändernde Kapazität an der Sensorelektrode ein Abstand zwischen zwei Komponenten einer Werkzeugmaschine bestimmt wird. Derart kann eine erfindungsgemäße Sensoranordnung die Automation bei Werkzeugmaschinen und bei Maschinen im Allgemeinen erheblich vereinfachen und einen automatisierten Betrieb von Maschinen verbessern, bei denen die Durchführung aufeinanderfolgender Prozessschritte von einer bestimmten Lage bzw. Position zweier Komponenten zueinander abhängt und diese sensorisch zu erfassen ist. Durch die Verbesserung des Messeffekts aufgrund der gezielten, wenigstens teilweisen Kompensation parasitärer Kapazitäten in der Auswerteschaltung kann die entsprechende Lage bzw. Position genauer und folglich mit geringerer Fehlertoleranz bestimmt werden.

Darüber hinaus ist beispielsweise auch eine Anwendung in einem Füllstandsensor denkbar, um mittels der Sensorelektrode den Füllstand einer Flüssigkeit in einem Behälter kapazitiv zu bestimmen.

Ein weiterer Aspekt der vorliegenden Erfindung ist ein Verfahren zur Messung einer Kapazitätsänderung an wenigstens einer Sensorelektrode mit einer Grundkapazität gemäß dem Anspruch 15.

Hierbei ist vorgesehen, dass

- die Sensorelektrode mit einer Auswerteschaltung gekoppelt ist, die wenigstens einen Verstärker und einen dem Verstärker nachgeschalteten Schmitt-Trigger umfasst,

- über die Auswerteschaltung die Sensorelektrode wiederholt entladen und aufgeladen wird, so dass anhand der Frequenz, mit der das Entladen und Aufladen erfolgt, an einem dem Schmitt-Trigger nachgeschalteten Ausgang auf die Größe der Kapazität an der Sensorelektrode geschlossen werden kann,

- die Spannung über der Sensorelektrode an einen Eingang des Verstärkers angelegt wird und eine Kompensationsspannung an einem Ausgang des Verstärkers erzeugt wird, und

- eine Kompensationskapazität vordefinierter elektrischer Kapazität vorgesehen wird, die mit dem Ausgang des Verstärkers verbunden und zu dem Verstärker derart parallel geschaltet ist, dass sich die Grundkapazität der Sensorelektrode verringert, um bei der Messung parasitäre Kapazitäten zu kompensieren.

In Übereinstimmung zu einer erfindungsgemäßen Sensoranordnung zeichnet sich ein erfindungsgemäßes Verfahren somit maßgeblich durch das Vorsehen einer Kompensationskapazität aus, die die mit dem Ausgang des Verstärkers verbunden und zu diesem parallel geschaltet ist. Die zuvor und nachfolgend für Ausführungsbeispiele einer erfindungsgemäßen Sensoranordnung erläuterten Merkmale gelten somit auch für die entsprechenden Varianten eines erfindungsgemäßen Messverfahrens und umgekehrt.

Weitere Vorteile und Merkmale der vorliegenden Erfindung werden bei der nachfolgenden Beschreibung von Ausführungsbeispielen anhand der Figuren deutlich werden.

Es zeigen:

Fig. 1    schematisch ein grundlegendes Schaltungskonzept für eine erfindungsgemäße Sensoranordnung;

Fig. 2    das Schaltbild für eine erste Ausführungsvariante einer erfindungsgemäßen Sensoranordnung mit einer Sensorelektrode und einer Feldbündelelektrode;

Fig. 3    ein Schaltbild zu einer Weiterbildung der Ausführungsvariante der Figur 2;

Fig. 4    ein Schaltbild zu einer zweiten Ausführungsvariante einer erfindungsgemäßen Sensoranordnung mit zwei Sensorelektroden.

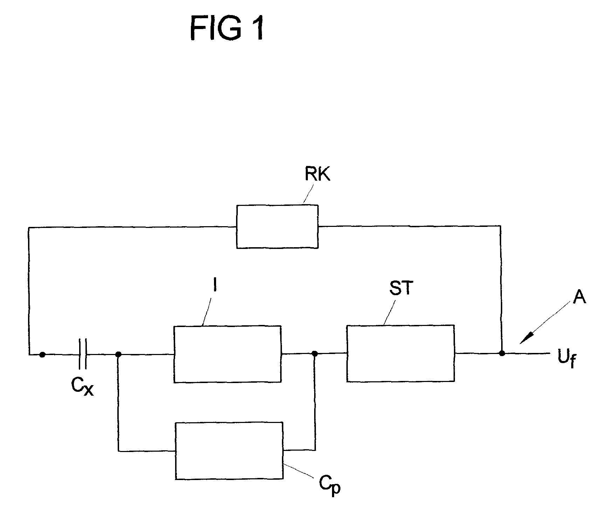

Die Figur 1 zeigt zunächst schematisch das grundlegende Schaltungskonzept einer erfindungsgemäßen Sensoranordnung, die zur Durchführung eines erfindungsgemäßen Verfahrens ausgebildet und vorgesehen ist. Bei dieser Sensoranordnung wird eine sich ändernde Kapazität zwischen einer Sensorelektrode als Messkapazität $C_X$ und der Elektronikmasse bzw. -erde gemessen, um zum Beispiel festzustellen, ob sich in der Umgebung der Sensorelektrode ein Objekt befindet und/oder - bei Verwendung der Sensoranordnung zur Abstandsmessung - ein Objekt der Sensorelektrode SE genähert hat. Dabei ist die zu messende Messkapazität $C_X$ mit einer Auswerteschaltung, hier umfassend einen (nicht-invertierenden) Verstärker I und einem diesem nachgeschalteten Schmitt-Trigger ST, verbunden. Der Ausgang des Schmitt-Triggers ST ist über eine Rückkopplung RK mit der Sensorelektrode SE verbunden.

Die Messkapazität Cx wird beispielsweise über einen Rückkopplungswiderstand mit einem Wechselstrom als getakteten Gleichstrom beaufschlagt. An einem, dem Schmitt-Trigger ST nachgeschalteten Ausgang A ist dann anhand eines Mess(spannungs)Signals $U_f$ eine Frequenz messbar, die von der Größe der Messkapazität $C_X$ abhängt. Ändert sich die Größe der Messkapazität $C_X$ beispielsweise durch ein in der Nähe der Sensorelektrode befindliches Objekt, verändert sich (proportional hierzu) die Frequenz zwischen Entladen und Aufladen der Messkapazität $C_X$. Folglich kann über die sich an dem Ausgang A einstellende Frequenz des Messsignals $U_f$ auf die momentane Größe der Messkapazität $C_X$ geschlossen werden bzw. die Messkapazität $C_x$ bestimmt werden.

Die dargestellte Sensoranordnung ist vorzugsweise für einen Abstandssensor oder einen Näherungsschalter vorgesehen, beispielsweise für die Automatisierung von Verstellprozessen bei (Werkzeug-)Maschinen. Hierbei ist üblicherweise die zu messende Änderung der Messkapazität Cx gegenüber einer Grundkapazität vergleichsweise gering, wobei hierbei als Grundkapazität die Kapazität der unbeeinflussten Sensorelektrode, d. h. die bei einer Kalibrierung der Sensoranordnung gemessene Größe der Messkapazität Cx, verstanden wird. Typischerweise liegt die zu erfassende und auszuwertende Änderung der Messkapazität $C_X$ im Bereich weniger pF ($\leq$ 10 pF) oder sogar unter 1 pF. Insbesondere bei einer derartigen Konstellation sind die über die Auswerteschaltung eingebrachten und mit gemessenen parasitären Kapazitäten sehr störend und beeinflussen den Messeffekt teilweise gravierend.

Bei einer erfindungsgemäßen Lösung gemäß der Figur 1 ist nun vorgesehen, dem Verstärker I ein kapazitives Bauelement als Kompensationskapazität $C_P$ mit einer vordefinierten Kapazität parallel zu schalten, so dass sich hierüber die (gemessene) Grundkapazität der Sensorelektrode SE verringert und bei der Messung parasitäre Kapazitäten kompensiert werden. Die Kompensationskapazität $C_P$ ist hierfür einerseits zwischen der Messkapazität $C_X$ und dem Eingang des Verstärkers I und andererseits zwischen dem Ausgang des Verstärkers I und dem Eingang des Schmitt-Triggers ST in die Sensoranordnung eingebunden.

Alternativ oder ergänzend zu einem separaten kapazitivem Bauelement zur Bereitstellung der Kompensationskapazität $C_P$ kann die Kompensationskapazität $C_P$ über ein geschickt gewähltes Schaltungslayout in die Schaltungsanordnung eingebracht sein, so dass ohnehin vorzusehende und bei der Messung kapazitiv wirkende Schaltungsteile (z.B. Leitungen) als eine Kompensationskapazität $C_P$ fungieren, mit der die gemessene Grundkapazität der Sensorelektrode SE verringert wird.

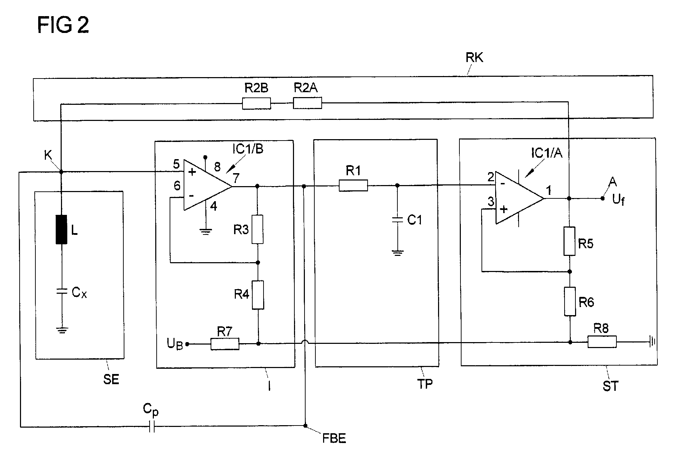

Die Figur 2 zeigt eine konkrete Ausführungsvariante des Schaltungskonzepts der Figur 1, bei der der Verstärker I als nicht-invertierender Verstärker mit einem Operationsverstärker IC1/B und der Schmitt-Trigger ST mit einem weiteren Operationsverstärker IC1/A versehen sind. Des Weiteren ist zwischen dem Verstärker I und dem Schmitt-Trigger ST ein Tiefpass TP mit einem Widerstand R1 und einem kapazitiven Bauelement C1 geschaltet, um hochfrequente Störungen zu unterdrücken.

Der nicht-invertierende Verstärker I weist in bekannter Art und Weise neben dem Operationsverstärker IC1/B zwei Widerstände R3 und R4 zur Bildung eines Spannungsteilers auf. Der Operationsverstärker IC1/B des Verstärkers I weist fünf Anschlusspins 4, 5, 6, 7 und 8 auf, wobei der Anschlusspin 5 dem nicht-invertierenden (positiven) Eingang des Operationsverstärkers IC1/B und der Anschlusspin 6 dem invertierenden (negativen) Eingang zugeordnet sind. Der Anschlusspin 4 stellt den Massepin dar und an dem Anschlusspin 8 liegt eine Versorgungsspannung $U_B$ an. Der Anschlusspin 7 wiederum stellt den Ausgang des Operationsverstärkers IC1/B dar. Mittels des Operationsverstärkers IC1/B erzeugt der Verstärker I an seinem durch den Anschlusspin 7 gekennzeichneten Ausgang eine definierte Kompensationsspannung, die proportional zu der Spannung über der Sensorelektrode SE bzw. über der Messkapazität Cx ist und die (um einen vorgegebenen Verstärkungsfaktor) gegenüber dieser Spannung erhöht ist.

Der Schmitt-Trigger ST weist neben dem Operationsverstärker IC1/A noch zusätzliche Widerstände R5 und R6 auf und ist in an sich bekannter Bauweise ausgebildet. Der Operationsverstärker IC1/A weist insbesondere an einem Anschlusspin 2 den invertierenden Eingang auf, der mit dem Tiefpass TP und hierüber mit dem Ausgang des Operationsverstärkers IC1/B des Verstärkers I verbunden ist. Dem nicht-invertierenden (positiven) Eingang des Operationsverstärkers IC1/A ist ein Anschlusspin 3 zugeordnet, an den das Ausgangssignal des Operationsverstärkers IC1/A zurückgeführt ist. Den Ausgang des Operationsverstärkers IC1/A definiert ein weiterer Anschlusspin 1.

Der Ausgang des Schmitt-Triggers ST ist über eine Rückkopplung RK - hier aufweisend zwei Widerstände R2A und R2B - mit dem Eingang des Operationsverstärkers IC1/B (am Anschlusspin 5) verbunden. An einem Knoten K der gezeigten Schaltung sind die Rückkopplung RK, der nicht-invertierende Eingang des Operationsverstärkers IC1/B, eine Sensorelektrode SE mit der Messkapazität $C_X$ und eine zu der Kompensationskapazität $C_P$ führende Anschlussleitung miteinander verbunden. Eine zweite zu der Kompensationskapazität $C_P$ führende Anschlussleitung ist dementsprechend zwischen dem Ausgang des Verstärkers I bzw. dem Ausgang des zugehörigen Operationsverstärkers IC1/B und dem Tiefpass TP angeschlossen.

Die Kompensationskapazität $C_P$ ist ferner (in Form eines Kondensators) zwischen die Sensorelektrode SE und eine Feldbündelelektrode FBE geschaltet. Die Feldbündelelektrode FBE bündelt dabei, wie z. B. aus der DE 195 12 150 A1 bekannt, ein von der Sensorelektrode SE erzeugtes elektrisches Feld in einen Messbereich. Hierfür ist die Feldbündelelektrode FBE beispielsweise um die Sensorelektrode SE vollständig umlaufend angeordnet. In der gezeigten Schaltung wirkt die Kompensationskapazität $C_P$ durch ihre Anordnung zwischen Sensorelektrode SE und Feldbündelelektrode FBE und parallel zu dem Verstärker I in der gezeigten Auswerteschaltung mitgemessenen parasitären Kapazitäten entgegen.

Ein ebenfalls der Unterdrückung hochfrequenter Störungen dienendes, induktives Bauelement L der Sensorelektrode SE sowie zusätzliche Widerstände R7 und R8 bei dem Verstärker I und dem Schmitt-Trigger ST komplettieren die analoge Sensorelektronik der gezeigten Schaltung.

Wie aus der Figur 2 ersichtlich ist, werden die Fußpunkte des Schmitt-Triggers ST und des nicht-invertierenden Verstärkers I über einen Spannungsteiler aus den zwei gleichgroßen, relativ niederohmigen Widerständen R7 und R8 zwischen der Versorgungsspannung $U_B$ und Masse angeschlossen. Hierdurch ist die gezeigte Schaltung mit einer einzelnen asymmetrischen Versorgungsspannung $U_B$ betreibbar.

Die Wirkung der Kompensationskapazität $C_P$ wird nachfolgend näher veranschaulicht werden.

Eine Spannung $u_{CX}$ über der Messkapazität $C_X$ baut sich mit einem Ladestrom

$$i_{Cx} = C_X \cdot \frac{du_{Cx}}{dt}$$

der über die Ausgangsspannung des Schmitt-Triggers ST und den hochohmigen Ladewiderstand R2A+R2B vorgegeben wird, näherungsweise gemäß der Gleichung

$$u_{Cx} = \frac{1}{C_X} \int_0^t i_{Cx} dt = \frac{1}{C_X} \int_0^t \frac{U_f}{R2A + R2B} dt = \frac{t}{C_X} \frac{U_f}{R2A + R2B}$$

auf.

Der Ladestrom der Messkapazität $C_X$ ist definitionsgemäß proportional zur Spannungsänderung $u_{CX}/dt$.

Die Spannung $u_{CX}$ über der quasi stationären Messkapazität $C_X$ steigt somit umgekehrt proportional zu der Messkapazität $C_X$. Über die Kompensationsspannung des nicht-invertierenden Verstärkers I und die Kompensationskapazität $C_P$ (zwischen dem Ausgang des nicht-invertierenden Verstärkers I und der Leitung der Sensorelektrode SE und der Senorelektrode SE selbst) fließt ein weiterer, zur Spannungsänderung $du_{Cp}/dt$ proportionaler Kompensationsstrom

$$i_{Cp} = C_P \frac{du_{Cp}}{dt},$$

in den Knoten K an der Messkapazität $C_X$, der die Spannung $u_{Cx}$ schneller ansteigen lässt (wie bei einer Verkleinerung der Messkapazität $C_X$):

$$u_{Cx} = \frac{1}{C_P} \int_0^t i_{Cp} dt.$$

Beide Effekte überlagern sich. In Verbindung mit dem Kompensationsstrom aus dem nicht-invertierenden Verstärker I wirkt die Kompensationskapazität $C_P$ wie eine Reduktion eines konstanten Grundanteils $C_0$ der Messkapazität $C_X$ (Grundkapazität):

$$C_X = C_0 + \Delta C \text{ mit } C_0 \gg \Delta C.$$

$\Delta C$ symbolisiert hierbei die zu messende Vergrößerung der Messkapazität $C_X$ z. B. aufgrund der Annäherung eines Objekts an die Sensorelektrode SE. Durch diese Reduktion der Grundkapazität $C_0$ wird der Messeffekt erhöht.

Die über die Kompensationskapazität $C_P$ abfallende Spannung $u_{Cp}$ ist die Differenz der Kompensationsspannung, also der Ausgangsspannung des nicht-invertierenden Verstärkers und der Spannung über der Messkapazität $C_X$:

$$u_{Cp} = v \cdot u_{Cx} - u_{Cx},$$

wobei v den Verstärkungsfaktor des nicht-invertierenden Verstärkers I mit

$$v = 1 + \frac{R3}{R4}$$

darstellt.

Somit wird

$$u_{Cp} = \frac{R3}{R4} u_{Cx}$$

und der zusätzliche Strom in den Knoten K an der Messkapazität $C_X$

$$i_{Cp} = C_P \frac{du_{Cp}}{dt} = C_P \frac{R3}{R4} \frac{du_{Cx}}{dt}.$$

Mit dem Gesamtstrom in die Messkapazität $C_X$

$$i_{Cx} = \left( C_X - C_P \frac{R3}{R4} \right) \cdot \frac{du_{Cx}}{dt}$$

wird die Kondensatorspannung:

$$u_{Cx} = \frac{1}{C_X - C_P \frac{R3}{R4}} \int_0^t i_{Cx} dt$$

$$= \frac{1}{\Delta C + C_0 - C_P \frac{R3}{R4}} \int_0^t \frac{U_f}{R2A + R2B} dt = \frac{t}{\Delta C + C_0 - C_P \frac{R3}{R4}} \frac{U_f}{R2A + R2B}.$$

Über den nicht-invertierenden Verstärker I wird somit mit Hilfe der Kompensationskapazität $C_P$ (und gegebenenfalls einem weiteren hierzu parallel liegenden Kondensator) quasi eine negative Kapazität der Größe

$$C_P \frac{R3}{R4}$$

realisiert, die den verwendeten elektronischen Bauteilen inhärente und mitgemessene parasitäre (positive) Kapazitäten kompensiert. Der Messeffekt wird somit effektiv erhöht.

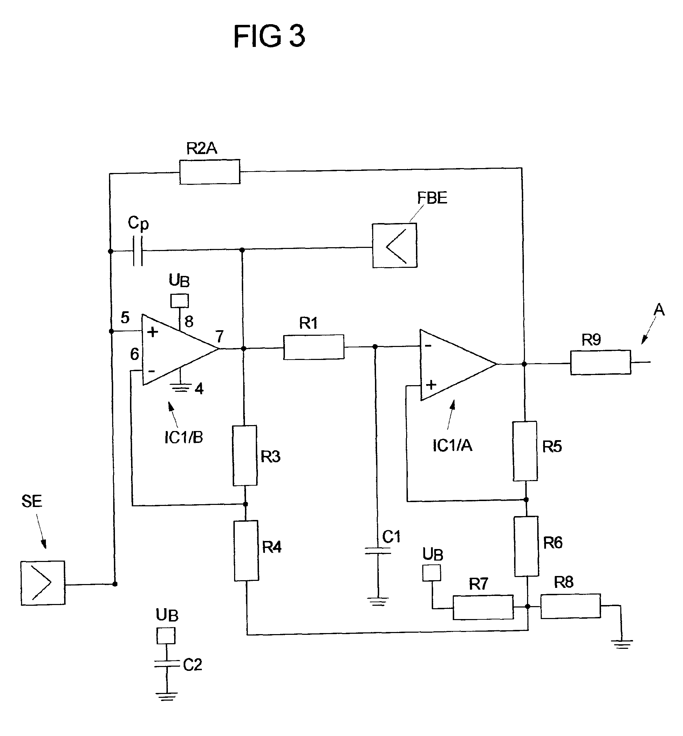

In der Figur 3 ist eine leicht abgewandelte Weiterbildung des Ausführungsbeispiels der Figur 2 gezeigt, bei der insbesondere anstelle zweier Widerstände R2A und R2B in der Rückkopplung RK lediglich ein Widerstand R2A vorgesehen ist. Für die Messung der Frequenz am Ausgang A ist ferner ein zusätzlicher Widerstand R9 vorgesehen. Im Übrigen stimmt der Schaltungsaufbau gemäß dem Ausführungsbeispiel der Figur 3 aber mit dem Schaltungskonzept der Figur 2 überein. Insbesondere ist auch hier die Kompensationskapazität $C_P$ in übereinstimmender Weise zwischen der Sensorelektrode SE und der Feldbündelelektrode FBE derart geschaltet, dass sie (rechnerisch) quasi wie eine negative Kapazität wirkt und parasitäre Kapazitäten bei der Messung kompensiert.

Im vorliegenden Fall ist ein Schaltungslayout mit einem einzelnen Operationsverstärkerbaustein mit den Operationsverstärkern IC1/A und IC1/B gewählt, bei dem der Operationsverstärker IC1/B des nicht-invertierenden Verstärkers I in besonderer Weise angeordnet und verschaltet ist, so dass parasitäre Kapazitäten bei der Messung zusätzlich reduziert werden. Hierzu arbeitet der Operationsverstärker IC1/B nicht nur mit einem sehr geringen Eingangsstrom. Vielmehr ist zusätzlich noch vorgesehen, dass der Anschlusspin 5 für den nicht-invertierenden (positiven) Eingang des Operationsverstärkers IC1/B den äußersten von vier nebeneinander liegenden (Eingangs-)Anschlusspins 5, 6, 7, 8 darstellt und der Anschlusspin 5 ausschließlich in unmittelbarer Nachbarschaft zu dem Anschlusspin 6 für den invertierenden (negativen) Eingang des Operationsverstärkers IC1/B liegt. Zwischen den beiden Anschlusspins 5 und 6 ist dementsprechend kein weiterer Anschlusspin des Operationsverstärkers IC1/B vorgesehen.

Einerseits durch die Anordnung des Anschlusspins 5 am Rand des Bausteins für den Operationsverstärker IC1/B und andererseits aufgrund der Tatsache, dass der Operationsverstärker IC1/B von sich aus eine Spannungsdifferenz zwischen den positiven und negativen Eingängen zu Null regelt, werden parasitäre Kapazitäten zusätzlich vermieden. Die Anschlusspins 5, 6, 7 und 8 für den nicht-invertierenden Eingang, den invertierenden Eingang und den Ausgang des Operationsverstärkers IC1/B und für den Anschluss an die Versorgungsspannung $U_B$ sind nebeneinander angeordnet und möglichst nahe an der Sensorelektrode SE, um Störeinflüsse bzw. störende Potentiale zu vermeiden. Der Anschluss- bzw. Massepin 4 des Operationsverstärkers IC1/B ist zu eben diesem Zweck bei einem bevorzugten Schaltungslayout möglichst weit zu der Sensorelektrode SE beabstandet und auf einer anderen Seite des Operationsverstärkerbausteins angeordnet als die Anschlusspins 5, 6, 7 und 8.

Darüber hinaus besitzt der Anschlusspin 5 für den nicht-invertierenden (positiven) Eingang des Operationsverstärkers IC1/B vorzugsweise auch nur kurze Anschlussleitungen.

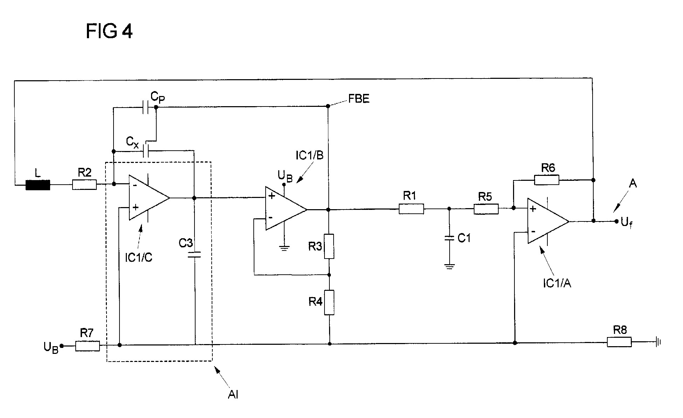

Mit der Figur 4 wird ein Schaltungsaufbau für eine zweite mögliche Ausführungsvariante einer erfindungsgemäßen Sensoranordnung veranschaulicht, bei der zwei Sensorelektroden SE, hier weiterhin repräsentiert durch eine einzelne Messkapazität $C_x$ in Kombination mit einer Feldbündelelektrode FBE verwendet sind.

Der Aufbau der Sensoranordnung der Figur 4 unterscheidet sich von den Ausführungsvarianten der Figuren 2 und 3 vor allem durch die zusätzliche Einbettung eines dem nicht-invertierenden Verstärker I vorgeschaltetem Integrierers AI (auch als "aktiver Integrator" bezeichnet). Dieser zusätzliche Integrierer AI weist neben einem weiteren Operationsverstärker IC1/C ein zusätzliches kapazitives Bauelement C3 auf, das an dem Ausgang des Operationsverstärkers IC1/C des Integrierers AI angeschlossen ist. Die Messkapazität $C_X$ und die Kompensationskapazität $C_P$ sind jeweils mit dem invertierenden (negativen) Eingang des zusätzlichen Operationsverstärkers IC1/C verbunden.

Die auf den invertierenden Eingang des Operationsverstärkers IC1/C geschaltete zusätzliche Sensorelektrode SE kann vorteilhaft zumindest teilweise von einer weiteren, vorzugsweise auf Elektronikmasse geschalteten Elektrode umgeben sein. Des Weiteren kann die Feldbündelelektrode FBE zumindest einen Teil der ersten, am Ausgang des Operationsverstärkers IC1/C angeschlossenen Sensorelektrode SE umgeben. Dabei können die auf Elektronikmasse geschaltete Elektrode und die Feldbündelelektrode FBE die jeweilige Sensorelektrode SE in beliebiger Form umlaufen. Beispielsweise können die Elektrode und die Feldbündelelektrode FBE die jeweilige Sensorelektrode SE rahmenförmig, insbesondere halbkreisförmig, kreisförmig oder rechteckförmig umgeben.

**Bezugszeichenliste**

| | |
|---|---|
| 1 - 8 | Anschlusspin |
| A | Ausgang |
| AI | Aktiver Integrator |
| Co | Grundkapazität der Messkapazität $C_x$ |
| C1, C2, C3 | Kapazitives Bauelement |
| $C_p$ | Kompensationskapazität |
| $C_x$ | Messkapazität |
| I | Verstärker |
| IC1/A, IC1/B, IC1/C | Operationsverstärker |
| FBE | Feldbündelelektrode |
| K | Knoten |
| L | Induktives Bauelement |
| R1, R2A, R2B, R3 - R9 | Widerstand |
| RK | Rückkopplung |
| SE | Sensorelektrode |
| ST | Schmitt-Trigger |
| TP | Tiefpass |

$U_B$ Versorgungsspannung
$U_f$ Messsignal

**Patentansprüche**

1. Sensoranordnung zur Messung einer Kapazitätsänderung an wenigstens einer Sensorelektrode mit einer Grundkapazität, wobei die Grundkapazität ($C_0$) den bei einer Messung konstanten Grundanteil einer Messkapazität ($C_x$) bildet und wobei

   - die Sensorelektrode mit einer Auswerteschaltung gekoppelt ist, die wenigstens einen Verstärker (I) und einen dem Verstärker (I) nachgeschalteten Schmitt-Trigger (ST) umfasst, und
   - über die Auswerteschaltung die Sensorelektrode (SE) wiederholt entladbar und aufladbar ist, so dass anhand der Frequenz, mit der das Entladen und Aufladen erfolgt, an einem dem Schmitt-Trigger (ST) nachgeschalteten Ausgang (A) auf die Größe der Messkapazität ($C_x$) an der Sensorelektrode (SE) geschlossen werden kann,

   **dadurch gekennzeichnet, dass**
   an einem Eingang (5) des Verstärkers (I) die Spannung über der Sensorelektrode (SE) anliegt und an einem Ausgang (7) des Verstärkers (I) eine Kompensationsspannung erzeugt wird, und dass eine Kompensationskapazität (Cp) vordefinierter elektrischer Kapazität mit dem Ausgang (7) des Verstärkers (I) verbunden und zu dem Verstärker (I) parallel geschaltet ist, so dass die mitgemessene Grundkapazität (Co) der Sensorelektrode (SE) verringert ist, um bei der Messung parasitäre Kapazitäten zu kompensieren.

2. Sensoranordnung nach Anspruch 1, **dadurch gekennzeichnet, dass** die Kompensationskapazität (Cp) durch wenigstens ein separates kapazitives Bauelement der Sensoranordnung bereitgestellt ist.

3. Sensoranordnung nach Anspruch 1 oder 2, **dadurch gekennzeichnet, dass** der Verstärker (I) derart ausgebildet ist, dass die von ihm erzeugte Kompensationsspannung zu der Spannung über der Sensorelektrode (SE) proportional und gegenüber dieser erhöht ist.

4. Sensoranordnung nach einem der Ansprüche 1 bis 3, **dadurch gekennzeichnet, dass** der Verstärker (I) einen Operationsverstärker (IC1/B) umfasst.

5. Sensoranordnung nach Anspruch 4, **dadurch gekennzeichnet, dass** der Verstärker als nicht-invertierender Verstärker (I) ausgebildet ist.

6. Sensoranordnung nach einem der Ansprüche 1 bis 5, **dadurch gekennzeichnet, dass** zusätzlich zu der wenigstens einen Sensorelektrode (SE) eine Feldbündelelektrode (FBE) vorgesehen ist, die derart ausgebildet und geschaltet ist, dass ein von der Feldbündelelektrode (FBE) erzeugtes elektrisches Feld eine räumliche Verteilung eines von der Sensorelektrode (SE) erzeugten elektrischen Feldes derart beeinflusst, dass das Feld der Sensorelektrode (SE) in einem Messbereich gebündelt wird.

7. Sensoranordnung nach Anspruch 6, **dadurch gekennzeichnet, dass** die Feldbündelelektrode (FBE) mit dem Ausgang des Verstärkers (I) verbunden ist.

8. Sensoranordnung nach Anspruch 6 und 7, **dadurch gekennzeichnet, dass** die zur Kompensation parasitärer Kapazitäten vorgesehene Kompensationskapazität ($C_P$) zwischen die Feldbündelelektrode (FBE) und die Sensorelektrode (SE) und/oder zwischen den Ausgang (7) des Verstärkers (I) und die Sensorelektrode (SE) geschaltet ist.

9. Sensoranordnung nach einem der vorhergehenden Ansprüche, **dadurch gekennzeichnet, dass** die Auswerteschaltung dazu ausgebildet und vorgesehen ist, mit einer einzelnen asymmetrischen Versorgungsspannung ($U_B$) betrieben zu werden.

10. Sensoranordnung nach einem der vorhergehenden Ansprüche, **dadurch gekennzeichnet, dass** eine zweite Sensorelektrode und ein dem Verstärker (I) vorgeschalteter Integrierer (AI) vorgesehen sind.

11. Sensoranordnung nach einem der vorhergehenden Ansprüche, **dadurch gekennzeichnet, dass** die Auswerteschaltung auf einer Leiterplatte untergebracht ist.

**12.** Sensoranordnung nach einem der Ansprüche 4 oder 5 und nach dem Anspruch 11, **dadurch gekennzeichnet, dass**

- der Operationsverstärker (IC1/B) mehrere an der Leiterplatte nebeneinander liegende Anschlusspins (5, 6, 7, 8) aufweist,
- die Sensorelektrode (SE) mit dem nichtinvertierenden Eingang des Operationsverstärkers (IC1/B) über einen Anschlusspin (5) des Operationsverstärkers (IC1/B) verbunden ist und
- der Anschlusspin (5) zum einen den äußersten Anschlusspin der nebeneinander liegenden Anschlusspins (5, 6, 7, 8) bildet und der Anschlusspin (5) zum anderen unmittelbar neben dem Anschlusspin (6) für den invertierenden Eingang des Operationsverstärkers (IC1/B) liegt.

**13.** Sensoranordnung nach einem der vorhergehenden Ansprüche, **dadurch gekennzeichnet, dass** die Sensoranordnung dazu ausgebildet und vorgesehen ist, durch eine sich ändernde Kapazität ($C_x$) an der Sensorelektrode (SE) zu bestimmen, ob sich ein Objekt der Sensorelektrode (SE) genähert hat und/oder sich ein Objekt in einem Umgebungsbereich um die Sensorelektrode befindet.

**14.** Sensoranordnung nach einem der vorhergehenden Ansprüche, **dadurch gekennzeichnet, dass** die Sensoranordnung dazu ausgebildet und vorgesehen ist, durch eine sich ändernde Kapazität ($C_x$) an der Sensorelektrode (SE) einen Abstand zwischen zwei Komponenten einer Werkzeugmaschine zu bestimmen.

**15.** Verfahren zur Messung einer Kapazitätsänderung an wenigstens einer Sensorelektrode mit einer Grundkapazität, wobei die Grundkapazität ($C_0$) den bei einer Messung konstanten Grundanteil einer Messkapazität ($C_x$) bildet und wobei

- die Sensorelektrode mit einer Auswerteschaltung gekoppelt ist, die wenigstens einen Verstärker (I) und einen dem Verstärker (I) nachgeschalteten Schmitt-Trigger (ST) umfasst, und
- über die Auswerteschaltung die Sensorelektrode (SE) wiederholt entladen und aufgeladen wird, so dass anhand der Frequenz, mit der das Entladen und Aufladen erfolgt, an einem dem Schmitt-Trigger (ST) nachgeschalteten Ausgang (A) auf die Größe der Messkapazität ($C_x$) an der Sensorelektrode (SE) geschlossen werden kann,

**dadurch gekennzeichnet, dass**
die Spannung über der Sensorelektrode (SE) an einen Eingang (5) des Verstärkers (I) angelegt wird und eine Kompensationsspannung an einem Ausgang (7) des Verstärkers (I) erzeugt wird, und dass eine Kompensationskapazität (Cp) vordefinierter elektrischer Kapazität vorgesehen wird, die mit dem Ausgang (7) des Verstärkers (I) verbunden und zu dem Verstärker (I) parallel geschaltet ist, so dass sich die mitgemessene Grundkapazität (Co) der Sensorelektrode (SE) verringert ist, um bei der Messung parasitäre Kapazitäten zu kompensieren.

# FIG 1

# FIG 2

# FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19512150 A1